# EUROPEAN PATENT APPLICATION

(11) **EP 2 827 686 A1**
(43) Date of publication of application: **21.01.2015**
(21) Application number: 14161398.4
(22) Date of filing: 25.03.2014
(51) Int. Cl.: H05K 1/02, H05K 1/14

(54) **Flexible printed circuit film and display device including the same**

(30) Priority: 18.07.2013 KR 20130084786
(71) Applicant: Samsung Display Co., Ltd., Yongin-City, Gyeonggi-Do, 446-711 (KR)
(72) Inventor: Cho, Yong-Heon, Cheonan-si (KR)
(74) Representative: Gulde & Partner

(57) **Abstract**

A display device includes: a display substrate (200) and a flexible printed circuit film (100) connected to the display substrate (200). The flexible printed circuit film (100) includes a main body (10) including a bending region (B), and a first cover layer (20) disposed on a first side of the main body (10), wherein the first cover layer (20) has a first opening (21) exposing a portion of the bending region (B).

## Description

### (a) Technical Field

The present disclosure relates to a flexible printed circuit film and a display device including the same.

### (b) Discussion of the Related Art

Display devices include, for example, liquid crystal displays (LCD), organic light emitting diode (OLED) displays, or the like. For example, the organic light emitting diode display includes a display substrate which provides pixel areas and non-pixel areas, and an encapsulation substrate disposed to face the display substrate for encapsulation and bonded with the display substrate by a sealant such as an epoxy.

A plurality of light emitting elements, which are connected in a matrix manner so as to configure the pixels, are formed between scan lines and data lines in the pixel area of the display substrate. A scan driver and a data driver, from which the scan lines and the data lines extend in the pixel area, process signals provided from the outside via a pad, supply the signals to the scan lines and the data lines, and are formed in the non-pixel area.

The display device further includes, for example, a flexible printed circuit film which receives a video signal from the outside of the display substrate and respectively applies the driving signals to the gate lines and the data lines.

The flexible printed circuit film is bent such that a portion of the flexible printed circuit film is positioned under the display substrate. When bending the flexible printed circuit film, the flexible printed circuit film may be torn at the bent portion.

### SUMMARY

Exemplary embodiments of the present invention provide a flexible printed circuit film with increased durability of a bending region, and a display device including the same.

A flexible printed circuit film according to an exemplary embodiment of the present invention includes a main body including a bending region, and a first cover layer disposed on a first side of the main body, and the first cover layer has a first opening exposing a portion of the bending region.

The first cover layer may be disposed on opposing edges of the bending region on the first side of the main body.

A width of the first cover layer disposed on the opposing edges of the bending region on the first side of the main body may be in a range from about 0.5 mm to about 1.5 mm (more preferably from about 0.7 mm to about 1.2 mm). These values result in an improved trade-off between durability of the bending region which may be fairly increased and tension of the main body which is can be prevented from being rather increased.

A flexible printed circuit film according to an exemplary embodiment of the present invention may further include a second cover layer disposed on a second side of the main body which is opposite to the first side of the main body.

The second cover layer may include a second opening exposing a portion of the bending region.

The second cover layer may be disposed on opposing edges of the bending region on the second side of the main body.

A width of the second cover layer disposed on the opposing edges of the bending region on the second side of the main body may be in a range from about 0.5 mm to about 1.5 mm (more preferably from about 0.7 mm to about 1.2 mm). These values result in an improved trade-off between durability of the bending region which may be fairly increased and tension of the main body which is can be prevented from being rather increased.

Preferably, the main body is formed having a longish stripe-like shape. Preferably, the main body has a uniform width. Preferably, the main body has a uniform thickness. The main body has a first end and a second end. The bending region is disposed between the first end and second end.

Preferably, the first cover layer is formed with a longish stripe-like shape except in the bending region where the first cover layer has the first opening exposing a portion of the bending region. More preferably, the width of the first cover layer outside the bending region is equal to or greater than a width of the main body. In the bending region - where first opening is located - the sum of a first width of the first cover layer extending along a first lateral edge of the bending region, a second width of the first cover layer extending along a second (opposing) lateral edge of the bending region and a width of the first opening is equal to or greater than a width of the main body.

Preferably, the first cover layer has a uniform width. Preferably, the first cover layer has a uniform thickness outside the bending region. Preferably, the first width of the first cover layer extending along the first lateral edge of the bending region is equal to the second width of the first cover layer extending along the second (opposing) lateral edge of the bending region.

Preferably, the first opening has a shape of an rectangle. Preferably, the first opening extends over the complete bending region along a length direction while the first opening does not extend over the complete bending region along a width direction. Preferably, exactly one opening is formed in the first cover layer

Preferably, the second cover layer is formed with a longish stripe-like shape except in the bending region where the second cover layer has the second opening exposing a portion of the bending region. More preferably, the width of the second cover layer outside the bending region is equal to or greater than a width of the main body. In the bending region - where second opening is located - the sum of a third width of the second cover layer extending along the first lateral edge of the bending region, a fourth width of the second cover layer extending along the second (opposing) lateral edge of the bending region and a width of the second opening is equal to or greater than a width of the main body.

Preferably, the second cover layer has a uniform width. Preferably, the second cover layer has a uniform thickness outside the bending region. Preferably, the third width is equal to the fourth width.

Preferably, the second opening has a shape of an rectangle. Preferably, the second opening extends over the complete bending region along a length direction while the second opening does not extend over the complete bending region along a width direction Preferably, exactly one opening is formed in the second cover layer

Preferably, the first width is equal to the third width and/or the second width is equal to the fourth width. Preferably, the second opening has a shape of an rectangle. Preferably, the second opening extends over the complete bending region.

Preferably, the first cover layer and the second cover layer are arranged to be congruent with each other of opposite sides of the main body.

Preferably, a first width of the first cover layer extending along the first lateral edge of the bending region is smaller than a width of the first opening. Preferably, a ratio of the first width of the first cover layer extending along the first lateral edge of the bending region and a width of the first opening ranges between 0.01 and 0.5, more preferably 0.1 and 0.5.

Preferably, a third width of the second cover layer extending along the first lateral edge of the bending region is smaller than a width of the second opening. Preferably, a ratio of the third width of the second cover layer extending along the first lateral edge of the bending region and a width of the second opening ranges between 0.01 and 0.5, more preferably 0.1 and 0.5.

A display device according to an exemplary embodiment of the present invention includes a display substrate, and a flexible printed circuit film according to the present invention connected to the display substrate.

The display substrate may be a flexible substrate.

Preferably, one end of the flexible printed circuit film is connected such to display substrate and the other end of the flexible printed circuit film is connected such to an external device that the complete bending region is bent. Preferably, a cross section of the bending region is formed as an circular arc, more preferably as a semi circle.

Preferably, a length of the first cover layer and/or the second cover layer may be shorter than a length of the main body. Preferably, a length of the first cover layer is equal to a length of the second cover layer. Preferably, the first cover layer, the second cover layer and the main body have a congruent end section in one (lengthwise) end portion while the main body extends over the first cover layer and the second cover layer in the opposite (lengthwise) end portion.

A flexible printed circuit film according to an exemplary embodiment of the present invention includes a main body including a bending region, and a first cover layer disposed on a first side of the main body. The first cover layer has a first opening exposing a portion of the bending region.

In accordance with an exemplary embodiment of the present invention, a display device is provided. The display device includes a display substrate, a flexible printed circuit film connected to the display substrate, and an encapsulation substrate facing the display substrate and configured to encapsulate the display substrate.

The flexible printed circuit film includes a main body including a bending region, in which the bending region of the flexible printed circuit film is disposed between a portion of the flexible printed circuit film connected to the display substrate and a portion of the flexible printed circuit film disposed under the display substrate and extending parallel to the display substrate.

In addition, the flexible printed circuit film further includes a first cover layer disposed on a top surface of the main body on opposing edges of the bending region of the main body, and a second cover layer disposed on a bottom surface of the main body opposite to the top surface on opposing edges of the bending region of the main body. The first cover layer has a first opening exposing a portion of the bending region and the second cover layer has a second opening exposing a portion of the bending region. The first cover layer and the second cover layer are not disposed on a front surface of the main body. A width of the first cover layer disposed on the opposing edges of the bending region on the top surface of the main body is in a range from about 0.5 mm to about 1.5 mm and a width of the second cover layer disposed on the opposing edges of the bending region on the bottom surface of the main body is in a range from about 0.5 mm to about 1.5 mm.

As described above, according to an exemplary embodiment of the present invention, by disposing a cover layer at both edges of the bending region of the flexible printed circuit film, an increase of the tension of the flexible printed circuit film is not generated such that tearing may be prevented in the bending region.

### BRIEF DESCRIPTION OF THE DRAWINGS

Exemplary embodiments of the present invention can be understood in more detail from the following detailed description taken in conjunction with the attached drawings, in which:
FIG. 1 is a view of a side surface of a display device according to an exemplary embodiment of the present invention.
FIG. 2 is a view of a side surface of a flexible printed circuit film according to an exemplary embodiment of the present invention.
FIG. 3 is a view of a plane surface of a flexible printed circuit film according to an exemplary embodiment of the present invention.
FIG. 4 is a cross-sectional view of the flexible printed circuit film of FIG. 3 taken along the line IV-IV.

### DETAILED DESCRIPTION OF EXEMPLARY EMBODIMENTS

Exemplary embodiments of the present invention will now be described in detail with reference to the attached drawings. Exemplary embodiments of the present invention may be modified in many different forms, and should not be construed as being limited to exemplary embodiments set forth herein.

In the drawings, the thickness of layers and regions may be exaggerated for clarity. In addition, when a layer is described to be formed on another layer or on a substrate, this means that the layer may be formed on the other layer or on the substrate, or a third layer may be interposed between the layer and the other layer or the substrate. Like numbers refer to like elements throughout the specification.

As used herein, the singular forms, "a", "an" and "the" are intended to include the plural forms as well, unless the context clearly indicates otherwise.

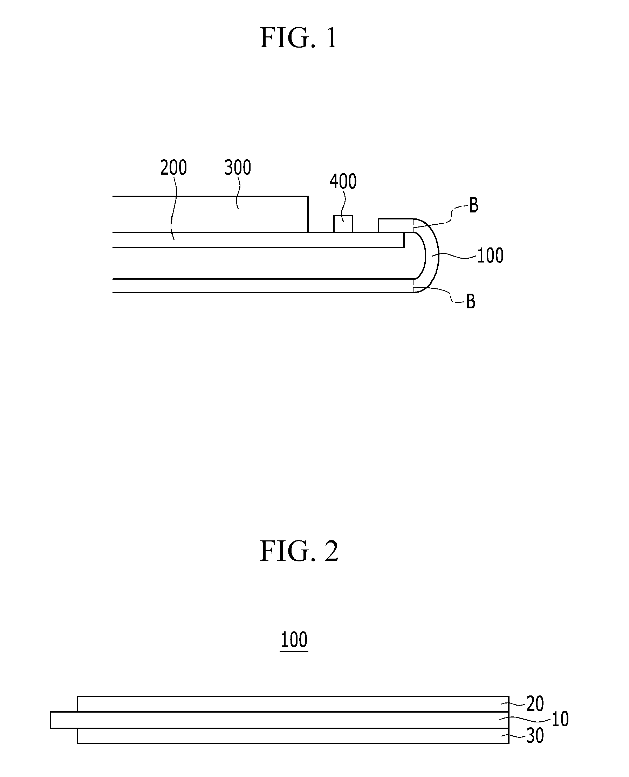

A display device according to an exemplary embodiment of the present invention will now be described with reference to FIG. 1.

FIG. 1 is a view of a side surface of a display device according to an exemplary embodiment of the present invention.

Referring to FIG. 1, a display device according to an exemplary embodiment of the present invention includes, for example, a display substrate 200, an encapsulation substrate 300 facing the display substrate 200, and a flexible printed circuit film 100 receiving a video signal from outside the display substrate 200 and transmitting the video signal to the display substrate 200.

The display substrate 200 may be, for example, a flexible substrate, and includes a plurality of light emitting elements forming pixels each connected to a gate line and a data line. Also, the display substrate 200 includes, for example, a driving chip 400 transmitting the driving signals to the gate lines and the data lines.

The encapsulation substrate 300 for encapsulating the display substrate 200 may be combined to the display substrate 200 by, for example, an encapsulation material (sealant). For example, in an embodiment, the encapsulation substrate 300 may be formed of a glass, quartz, ceramic or plastic material but exemplary embodiments of the present invention are not limited thereto.

The encapsulation material (sealant) may include, for example, potassium oxide (K₂O), iron oxide (Fe₂O₃), antimony oxide (Sb₂O₃), zinc oxide (ZnO), phosphorous pentoxide (P₂O₅), vanadium oxide (V₂O₅), aluminum oxide (Al₂O₃), boron oxide (B₂O₃), tungsten oxide (WO₃), tin oxide (SnO), lead oxide (PbO), and a mixture of two or more of the foregoing.

The flexible printed circuit film 100 includes, for example, a bending region (B). One end of the flexible printed circuit film 100 is connected to of an upper surface of the display substrate 200 in a peripheral area (i.e. a non-pixel area) of the display substrate 200 and is bent at the bending region (B) such that a portion of the flexible printed circuit film 100 is positioned under the display substrate 200 - i.e. facing a lower surface of the display substrate 200 opposite to the upper surface - and the other end of the flexible printed circuit film 100 is connected to an external device.

Here, the bending region (B) of the flexible printed circuit film 100 is positioned between the portion of the flexible printed circuit film 100 connected to the display substrate 200 and a portion of the flexible printed circuit film 100 positioned under the display substrate 200 and extending parallel to the display substrate 200.

Next, a flexible printed circuit film according to an exemplary embodiment of the present invention will be described with reference to FIG. 2 to FIG. 4.

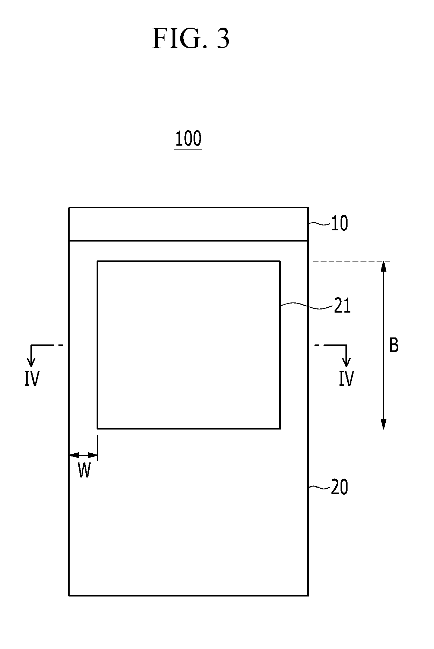

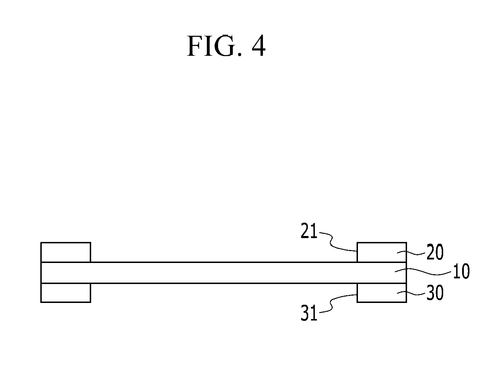

FIG. 2 is a view of a side surface of a flexible printed circuit film according to an exemplary embodiment of the present invention, FIG. 3 is a view of a plane surface of a flexible printed circuit film according to an exemplary embodiment of the present invention, and FIG. 4 is a cross-sectional view of the flexible printed circuit film of FIG. 3 taken along the line IV-IV.

Referring to FIG. 2 to FIG. 4, the flexible printed circuit film 100 according to an exemplary embodiment of the present invention includes, for example, a main body 10, a first cover layer 20 disposed on a first side of the main body 10, and a second cover layer 30 disposed on a second side of the main body 10 opposite to the first side of the main body 10.

The first cover layer 20 and the second cover layer 30 protect the main body 10 and are attached to the main body 10 by, for example, an adhesive. For example, in an embodiment, the adhesive may be made of an acryl- or epoxy-based material. Also, a length of the first cover layer and/or the second cover layer may be, for example, shorter than a length of the main body 10.

The main body 10 includes, for example, a wire to transmit the driving signal to the driving chip 400.

The main body 10 includes the bending region (B). Preferably, the first cover layer 20 and the second cover layer 30 are not disposed on a region of the main body 10 corresponding to the end of the flexible printed circuit film 100 which is connected to the display substrate 200. The first cover layer 20 and the second cover layer 30 respectively include, for example, a first opening 21 and a second opening 31 exposing a portion of the bending region (B) of the main body 10. That is, the first cover layer 20 and the second cover layer 30 are only disposed at both lateral edges of the bending region (B) of the main body 10, as shown in Fig. 3. The lateral edges of the bending region (B) extend along the long side of the main body 10 from a portion of the main body 10 connected to the display substrate 200 and a portion of the main body 10 positioned under the display substrate 200. On the other hand, the first opening 21 and the second opening 31 may extend outside of the bending region (B).

When the first cover layer 20 and the second cover layer 30 are not formed on the bending region (B) of the main body 10, the durability of the bending region (B) may be deteriorated such that the edges of the bending region (B) may be torn. On the other side, when the first cover layer 20 and the second cover layer 30 are formed on the front surface of the bending region (B) of the main body 10, the tension of the main body 10 may be increased such that a lift-off phenomenon may be generated in the display substrate 200.

Accordingly, as shown in the present exemplary embodiment, the first cover layer 20 and the second cover layer 30 are respectively disposed only at both lateral edges of the bending region (B) of the main body 10 such that the durability of the bending region (B) may be increased without increasing the tension of the main body 10.

The widths of the first cover layer 20 and the second cover layer 30 disposed at both edges of the bending region B of the main body 10 are respectively in a range from, for example, about 0.5 mm to about 1.5 mm.

As described above, by disposing the cover layer at both edges of the bending region of the flexible printed circuit film, an increase of the tension of the flexible printed circuit film may not be generated such that tearing may be prevented in the bending region.

Having described exemplary embodiments of the present invention, it is further noted that it is readily apparent to those of ordinary skill in the art that various modifications may be made without departing from the scope of the invention which is defined by the metes and bounds of the appended claims.

## Claims

1. A flexible printed circuit (100) film comprising:
a main body (10) including a bending region (B); and
a first cover layer (20) disposed on a first side of the main body (10),
wherein the first cover layer (20) has a first opening (21) exposing a portion of the bending region (B).

2. The flexible printed circuit film of claim 1, wherein the first cover (20) layer is disposed on opposing lateral edges of the bending region (B) on the first side of the main body (10).

3. The flexible printed circuit film of claim 2, wherein a width of the first cover layer (20) disposed on the opposing lateral edges of the bending region (B) on the first side of the main body (10) is in a range from 0.5 mm to 1.5 mm.

4. The flexible printed circuit film of one of the preceding claims, further comprising a second cover layer (30) disposed on a second side of the main body (10) which is opposite to the first side of the main body (10).

5. The flexible printed circuit film of claim 4, wherein the second cover layer (30) includes a second opening (31) exposing a portion of the bending region (B).

6. The flexible printed circuit film of claim 5, wherein the second cover layer (30) is disposed on opposing lateral edges of the bending region (B) on the second side of the main body (10).

7. The flexible printed circuit film of claim 6, wherein a width of the second cover layer (30) disposed on the opposing lateral edges of the bending region (B) on the second side of the main body (10) is in a range from 0.5 mm to 1.5 mm.

8. A display device comprising:
a display substrate (200); and
a flexible printed circuit film (100) according to any of the preceding claims, wherein a first end portion of the flexible printed circuit film (100) is connected to an upper surface of the display substrate (200).

9. The display device of claim 8, wherein the bending region (B) of the flexible printed circuit film (100) is disposed between the first end portion of the flexible printed circuit film (100) and a portion of the flexible printed circuit film (100) disposed under the display substrate (200) and extending parallel to a lower surface of the display substrate (200) opposite to the upper surface of the display substrate (200).

10. The display device of one of claim 9, wherein a second end portion of the flexible printed circuit film (100) opposite to the first end portion is adapted to be connected to an external device for supplying a video signal.

11. The display device of one of claims 8 to 10, further comprising:
an encapsulation substrate (300) located on the upper surface of the display substrate (200); and
a driving chip (400) located on the upper surface of the display substrate (200) and electrically connected to the flexible printed circuit film (100).

12. The display device of one of claims 8 to 11, wherein the display substrate (200) is a flexible substrate.
